# EUROPEAN PATENT SPECIFICATION

(11) **EP 1 129 232 B1**
(45) Date of publication and mention of the grant of the patent: **01.10.2003**
(21) Application number: 99971870.3
(22) Date of filing: 11.11.1999
(51) Int. Cl.: C23C 14/56, C23C 14/50, B65G 35/06, B65G 17/00, B65G 47/244, B05D 5/06

(54) **APPARATUS FOR COATING OBJECTS THROUGH PVD**
VORRICHTUNG ZUM BESCHICHTEN VON GEGENSTÄNDEN MITTELS PVD
APPAREIL DE REVETEMENT D'OBJETS PAR PVD

(30) Priority: 11.11.1998 NL 1010531
(43) Date of publication of application: 05.09.2001
(73) Proprietor: Vacumetal B.V., 4903 RD Oosterhout (NL)
(72) Inventor: SCHRAUWEN, Cornelis, Petrus, Gerardus, NL-6662 NB Elst (NL); SCHUURMANS, Antonius, Jacobus, Willem, B-2900 Schoten (BE); SCHUURMANS, Gilbert, Cornelis, Hendricus, NL-4904 VG Oosterhout (NL)
(74) Representative: Eveleens Maarse, Pieter
(86) International application number: NL9900689
(87) International publication number: WO00028105

(56) References cited:
- EP-A- 0 293 229
- WO-A-97/28290
- DE-A- 2 109 061
- US-A- 4 148 967
- US-A- 4 637 342
- PATENT ABSTRACTS OF JAPAN vol. 095, no. 002, 31 March 1995 (1995-03-31) -& JP 06 322537 A (KOBE STEEL LTD), 22 November 1994 (1994-11-22)
- PATENT ABSTRACTS OF JAPAN vol. 096, no. 007, 31 July 1996 (1996-07-31) & JP 08 063747 A (MITSUBISHI CHEM CORP), 8 March 1996 (1996-03-08)
- PATENT ABSTRACTS OF JAPAN vol. 016, no. 485 (C-0993), 8 October 1992 (1992-10-08) & JP 04 176867 A (KAWASAKI STEEL CORP), 24 June 1992 (1992-06-24)

## Description

The present invention relates to an apparatus for coating objects by means of PVD (Physical Vapour Deposition), comprising:
- a preprocessing device for performing a preprocessing on the object;
- a PVD device for coating the object under an atmosphere differing from the ambient; and
- a postprocessing device for postprocessing the objects.

Such apparatus are generally known. They are for instance used to apply a thin layer of metal on plastics to give the object the appearance of metal. Examples hereof are for instance caps for cosmetics bottles, prizes such as presented at sporting events, car components and the like.

According to the prior art the objects for processing are placed on racks and provided with a lacquer coating. This lacquer coating enhances adhesion between the plastic from which the object is made and the metal coating to be applied thereto. The lacquer coating moreover provides a smooth surface, so that the reflection of the metal to be coated thereon is improved.

It is further pointed out that the pretreatment can also comprise a treatment prior to lacquering, such as a flame treatment. The surface properties of the plastic object are hereby changed so that the lacquer adheres better to the plastic.

The objects for processing are subsequently placed in a vacuum vessel.

A vacuum is then created in the vacuum vessel and, by means of evaporation of metal objects, metal vapour is introduced in the vacuum vessel which deposits on the lacquered components. This process is known as "Physical Vapour Deposition" (PVD).

After complete evaporation of the relevant element, air is again admitted into the vessel, whereafter the thus metallized objects on the racks can be removed.

The objects are thereafter subjected to a posttreatment, which is generally formed by a new lacquer treatment. It is pointed out here that the applied metal layer is extremely thin and is easily damaged. In order to protect this layer a protective lacquer coating is therefore applied. This lacquer coating further provides the option of changing the colour. In general use is made of aluminium as PVD material, wherein it is possible by colouring the lacquer to change the colour to for instance gold or copper colour.

A problem with this method generally used heretofore is that many operations must inevitably be performed manually, requiring much human labour. This is caused by the discontinuous character of the PVD process and by the relatively long drying time of the lacquers once they have been applied to the plastic objects. The work is moreover usually difficult.

WO-A-97/28290 discloses an apparatus for applying at least one coating to objects by means of vapour deposition (PVD) under vacuum, comprising:
- a PVD device for coating the object under a vacuum;
- at least one lock separating the PVD-device from the ambient;
- a transport device which extends though the PVD-device and into the lock;
- wherein the transport device is adapted to transport objects arranged on carriers, and
- the PVD device is adapted for semi-continuous treatment of objects arranged on the carriers.

This prior art apparatus is adapted to procedure cathode ray tubes, involving the sputtering of metal coatings on glass.

The aim of the invention is to provide an apparatus which is adapted to apply a metal coat on materials, which can only be coated if they have been covered by a coat of lacquer .

This aim is reached in that the apparatus comprises:
- a preprocessing device for performing a preprocessing on the object;
- a postprocessing device for postprocessing the objects;
- and that the transport device extends though said at least one lock, the preprocessing device and the postprocessing device.

The semi-continuous character of the PVD device enables successive treatment of the carriers with a series of objects. Because the transport device is adapted for this purpose, and moreover extends through the preprocessing device and postprocessing device, it becomes possible to treat the objects for vapour deposition without loading and unloading operations. This combination of measures thus enables the use of a certain degree of automation; only at the start do the objects have to be placed on the carriers, and after completion of the postprocessing they can be removed therefrom. Handling of the objects between the treatments, albeit placed on racks, is dispensed with.

According to a preferred embodiment the carriers are elongate and the transport device is adapted to move the carriers substantially in the longitudinal direction.

This configuration has the advantage that the objects arranged on the carriers are always readily accessible for the devices for applying lacquer and the like.
According to yet another preferred embodiment the transport device has a closed configuration and extends in two directions through the PVD device.

This also results in an attractive construction; when for instance further lock constructions are used, they can likewise be used in both directions, while the construction length of the apparatus can moreover be shortened by using it on two sides.

In addition, it is attractive to use buffers between the preprocessing device and the PVD device, and between the PVD device and the postprocessing device. These buffers have the function of compensating for the semi-continuity of the process performed in the PVD devices.

If the buffers are adapted to move the carriers in transverse direction, the buffers take up less space.

According to a particular preferred embodiment, the preprocessing device comprises a blower device for blowing dust from the objects for treating.

This blower device is preferably adapted to blow ionized air. According to yet another preferred embodiment the carriers are provided with interchangeable object holders.

This measure provides the advantage that the carriers can be used for different types of object; only the object holders have to be exchanged. This is particularly important in respect of the cost of the carriers; these carriers after all comprise expensive components manufactured with great precision.

In order to expose the objects properly on all sides to the processes to be applied, it is advantageous when the object holders are placed on vertically extending shafts mounted rotatably in the carriers.

This advantage is further enhanced when toothed wheels are arranged on the shafts for driving the shafts in rotation.

Because application of the lacquer in particular usually involves waste, it is important for the toothed wheels to be protected against this. For this purpose they are preferably arranged under the top side of the carrier. This provides the option of arranging protective means, so that lacquer dripping from the objects cannot reach the toothed wheels.

According to another preferred embodiment the toothed wheels are let into openings arranged in the carrier and the toothed wheels protrude outside the side walls of the carrier. This provides the possibility of providing the transport device with gear racks or chains for engaging in and rotating the toothed wheels during passage of the carriers, so that the shafts, and the objects placed thereon by means of the object holders, can thereby be rotated.

The present invention will be elucidated hereinbelow with reference to the annexed drawings, in which:
figure 1 shows a perspective schematic view of a complete apparatus according to the present invention;
figure 2 shows a perspective schematic view of the loading and unloading station of the apparatus shown in figure 1 as according to arrow II in figure 1;
figure 3 is a detail view as according to arrow III in figures 1 and 2;
figure 4 shows a perspective view of the buffer device according to the present invention as according to arrow IV in figure 1;
figure 5 is a perspective detail view as according to arrow V in figure 4;
figure 6 is a perspective detail view of figure 5;
figure 7 shows a perspective detail view as according to arrow VII in figure 4;
figure 8 shows a perspective detail view as according to arrow VIII in figure 4;
figure 9 shows a partly broken away perspective view of a vacuum evaporation chamber; and
figure 10 shows a perspective view of a carrier which is provided with diverse insert elements for carrying diverse objects for processing.

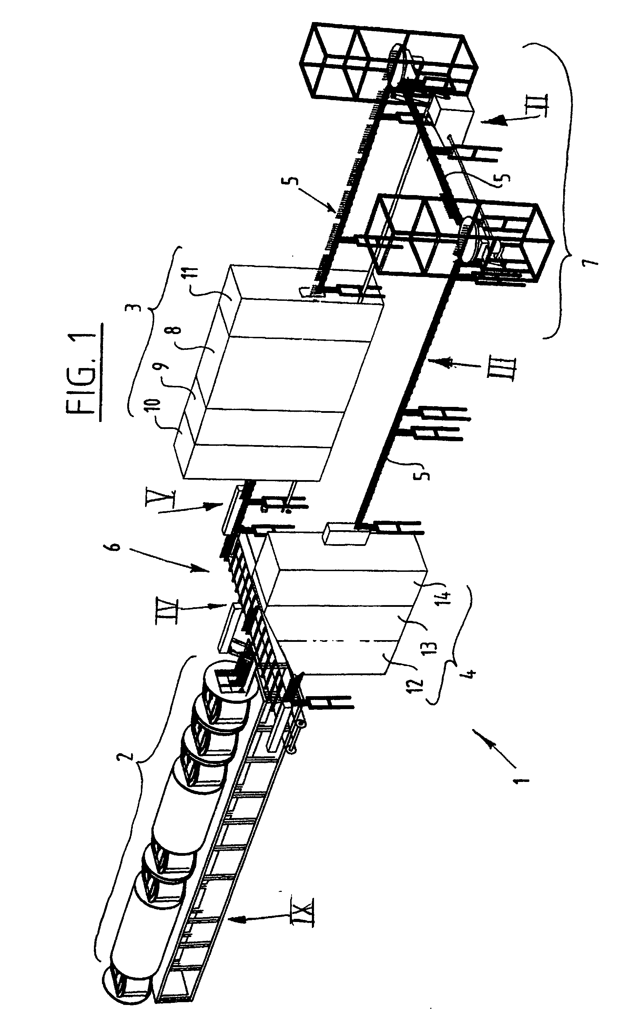

Figure 1 shows a metallizing apparatus designated in its entirety as 1. Broadly speaking, this metallizing apparatus is formed by a magnetron sputtering device 2, a preprocessing device 3 and a postprocessing device 4. Extending through each of these devices is a transport device 5. A shunting area 6 is arranged between preprocessing device 3 and PVD device 2 and between PVD device 2 and postprocessing device 4.

This shunting area serves to compensate for timing differences between the continuously operating preprocessing device 3 and postprocessing device 4 and the semi-continuously operating PVD device 2. Transport device 5 is closed and extends in both directions through PVD device 2. Between postprocessing device 4 and preprocessing device 3 the transport device 5 extends through a loading and unloading zone 7.

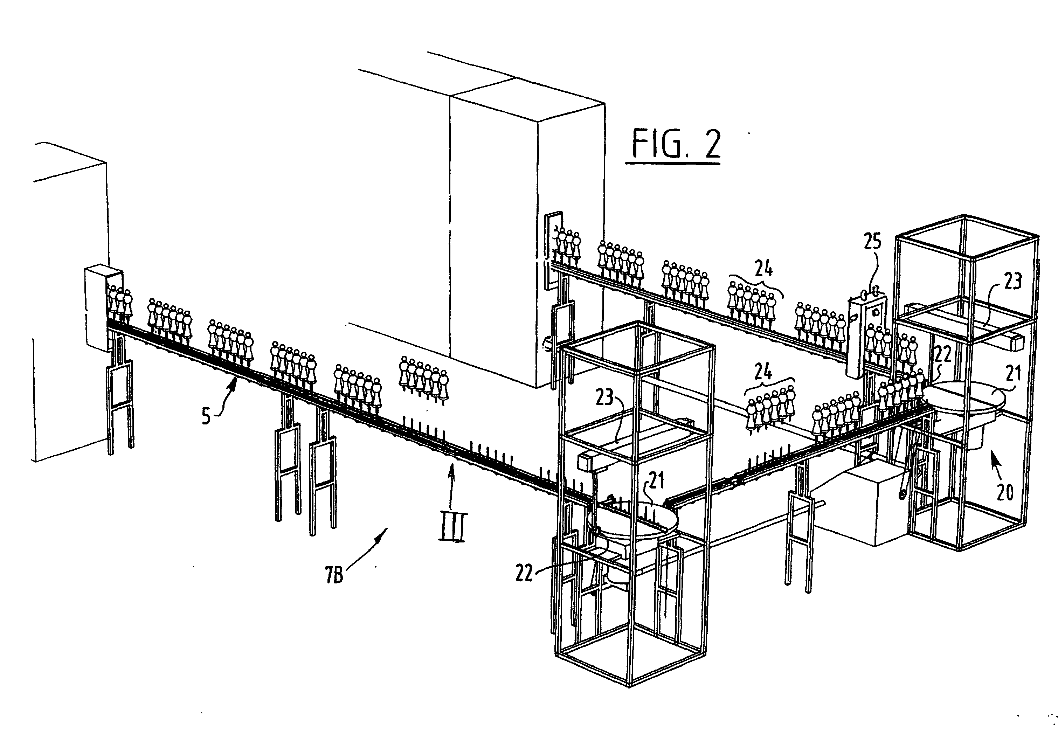

This loading and unloading zone is further shown in figure 2. This shows that transport device 5 has a U-shape at this location. At the positions where transport device 5 forms an angle are arranged rotation devices 20, each comprising a rotating disc 21. By means of rotating discs 21 it is possible to rotate carrier 15 through an angle of 90°. In order to move carriers 15 onto rotating discs 21 use is made of the drive device which is integrated into transport device 5. In order to move the carriers off the turned rotating disc 21 onto the following part of transport device 5, use is made of a pushing element 22 drivable by a linear drive element 23 arranged above the rotating disc.

The objects 24 for processing are placed on carriers 15 on that part of the transport device 5 placed between the two rotation devices 20. This part forms the loading zone 7A.

The finished products 24 can be taken off the part of transport device 5 preceding rotation device 20. This is the unloading zone 7B.

Figure 2 further shows how a check gate 25 is placed after the second rotation device 20 for checking the presence of and the location in a plane perpendicular to the direction of movement of the objects for treating. The presence detection is important for controlling for instance the lacquer device, so as to prevent an excessive quantity of lacquer being wasted by spraying while no object is passing.

The location detection serves to prevent objects placed askew on the holders from disrupting the movement of the carriers, whereby objects could become jammed or fall off. This would result in stopping of the process, removal of the objects in question and restarting of the process.

The first gate 25 placed after the loading station therefore serves mainly to determine whether the objects are placed correctly. Such a gate is also placed before the vacuum device. In the vacuum device the position of the objects is after all critical, and space is limited, this being particularly important in the case of large objects. Furthermore, the location of the objects on the carrier may have been changed due to the action of the spraying device.

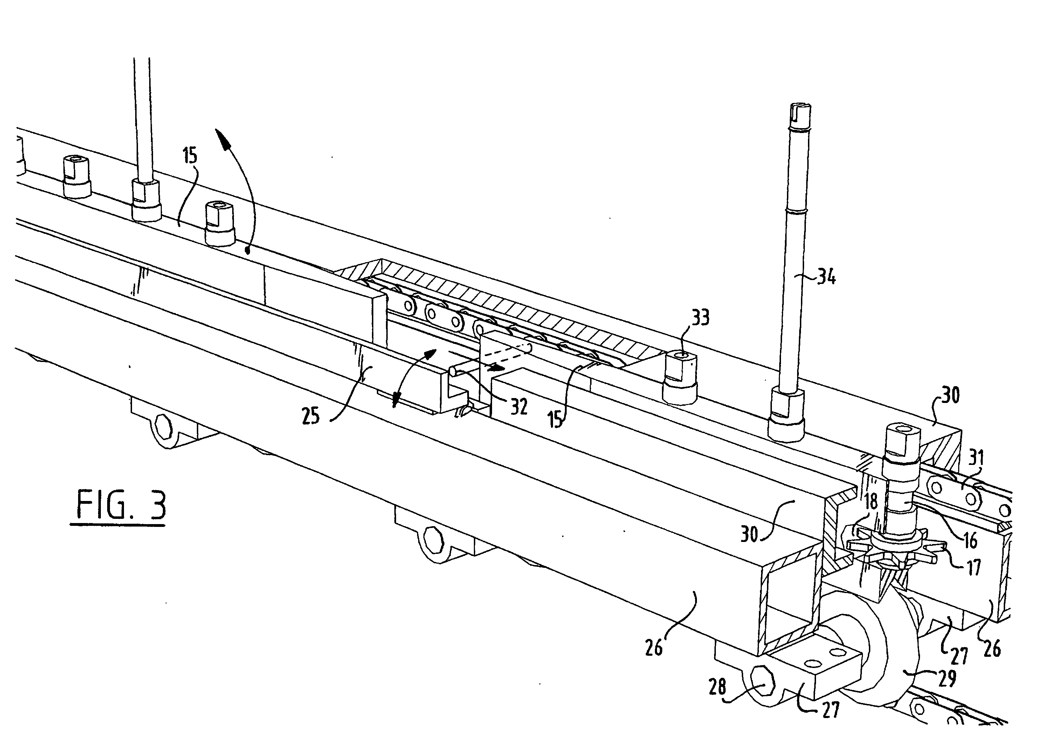

Figure 3 further shows the construction of transport device 5 at the location of unloading zone 7B.

Shown in figure 3 is that part. of the transport device which functions as unloading station.

The transport device comprises two tubular profiles 26 which are provided at regular distances on their underside with bearing units 27, in which are mounted shafts 28. A support wheel 29 is arranged on each of the shafts 28. Further arranged are two U-shaped profiles 30 which are each fixed against tubular profiles 27. In one of the two U-shaped profiles 30 is arranged a drive chain 31, which is provided with catch elements 32 for moving the carriers 15 along. The chain is guided back again via the underside of the transport device. This transport device extends through the entire apparatus according to the invention.

Carriers 15 are each formed by a carrier body 36, in which are mounted vertically extending shafts 16. Carrier body 36 is provided with recesses 18 through which shafts 16 extend and wherein toothed wheels 17 are arranged on the shafts at the location of recesses 18. These toothed wheels 17 serve to drive the shafts in rotation when for instance a gear rack or movable chain is arranged along the sides of profile 26.

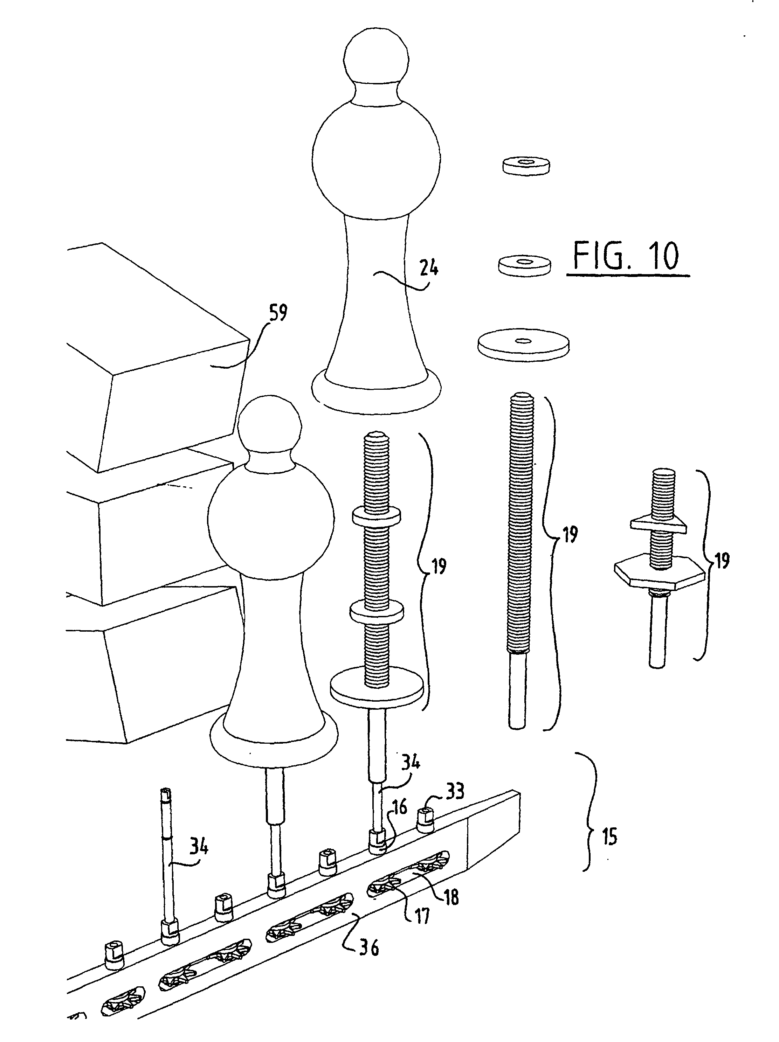

Each of the shafts are provided on their top with a recess 33 on which extension shafts 34 can be placed. Product holders adapted to the product for processing, which will be described with reference to figure 10, can then be placed on top of extension shafts 34. It is pointed out here that it is possible to use extension shafts 34 of different heights, so that it is possible to adjust the height of the objects for processing on the carriers.

A part of the profile 30 can otherwise be folded down at the location of unloading station 7B, so that carriers 15 can be taken away.

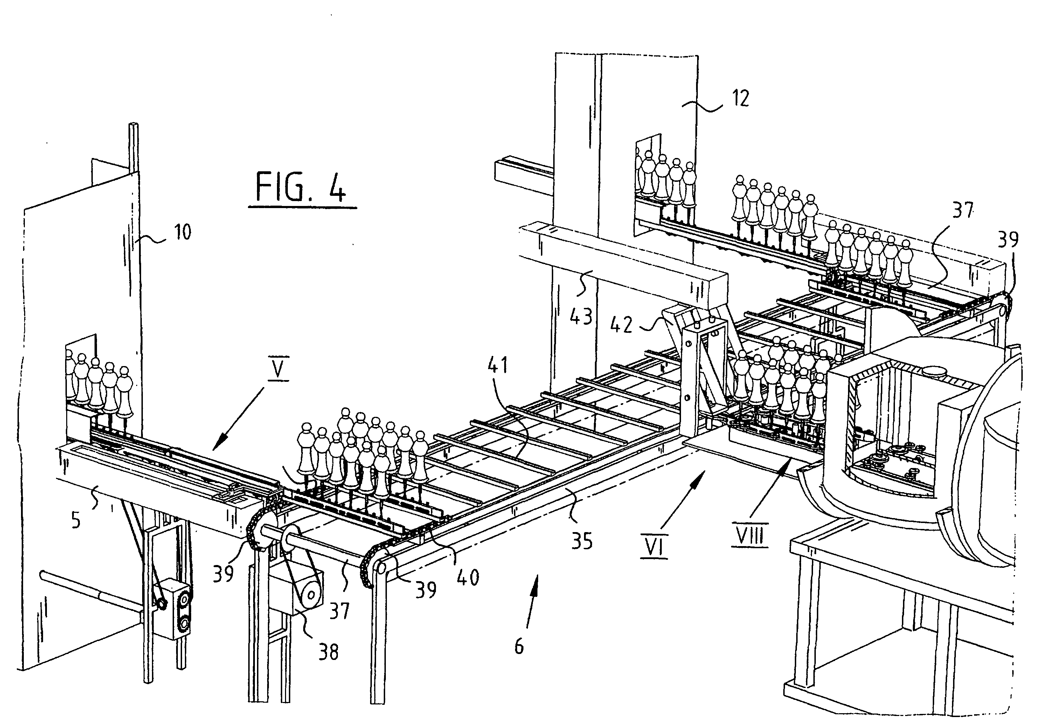

Further shown in figure 4 is a buffer device 6 which provides the synchronization of the essentially continuously operating preprocessing and postprocessing device and the semi-continuously operating vacuum metallization device.

Buffer device 6 is formed essentially by a frame 35 on which are placed two shafts 37, one of which is drivable by means of a motor 38. A chain wheel 39 is placed on each of the shafts 37, wherein a chain 40 is trained around each pair of chain wheels 39. Supports 41 are arranged between the two chains 40 for transporting carriers 15.

Shaft 36 is herein set into intermittent rotation such that supports 41 move intermittently. During the standstill periods of these carriers, the carriers from UV radiation device 10 are loaded onto the support 41 placed in line with transport device 5, while the carrier then placed in front of the transport device of the vacuum metallization device is simultaneously pushed onto the transport device of the metallization device by means of a pushing device 42. A carrier coming from the metallization device is simultaneously pushed onto the relevant support 41 and a carrier placed in front of the transport device of the UV lacquer spraying device 12 is pushed onto the relevant transport device. The device in question then moves one full stroke, whereafter this process is repeated.

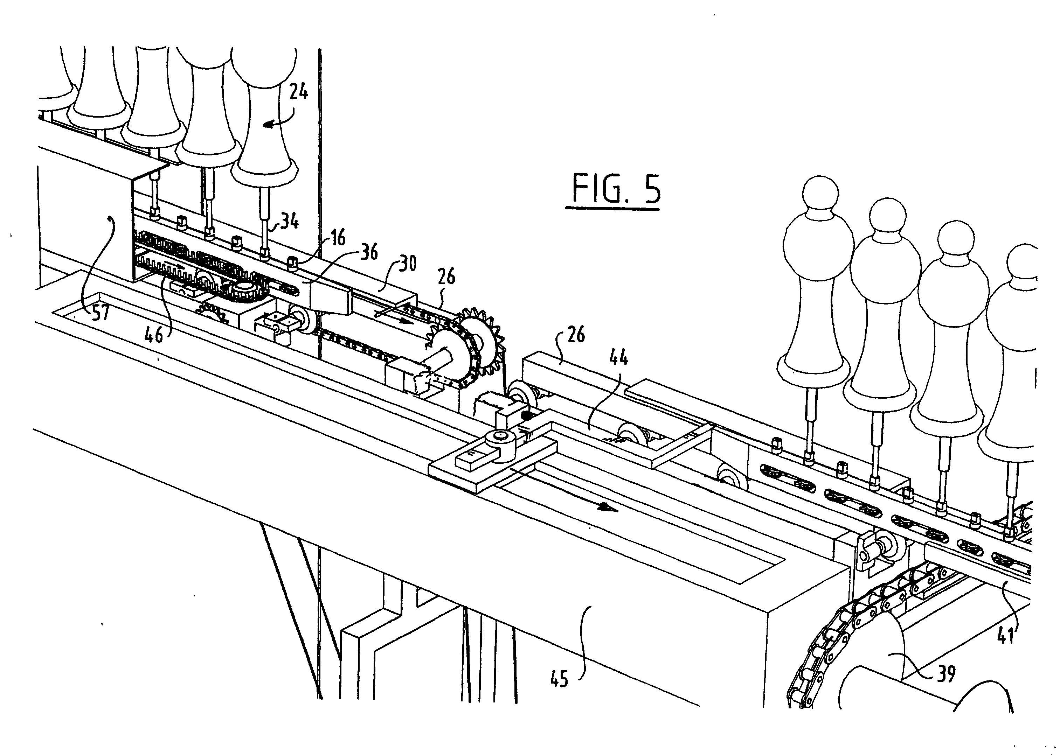

Figure 5 shows how a pushing device 42 is arranged for pushing a carrier 15 onto the relevant support 41. This pushing device 42 is herein driven by a linear drive member 43.

This device further shows how the shafts 16 of carrier 15 can be driven in rotation by means of toothed wheels 17, this independently of the linear movement of carrier 15. Use is made for this purpose of a chain 46, a part of which is arranged parallel to the direction of movement of carrier 15 and which can be driven independently of the transport movement. It will be apparent that it is possible to make use instead of for instance gear racks. These are then arranged fixedly so that the rotation movement is in fact coupled to the transport movement.

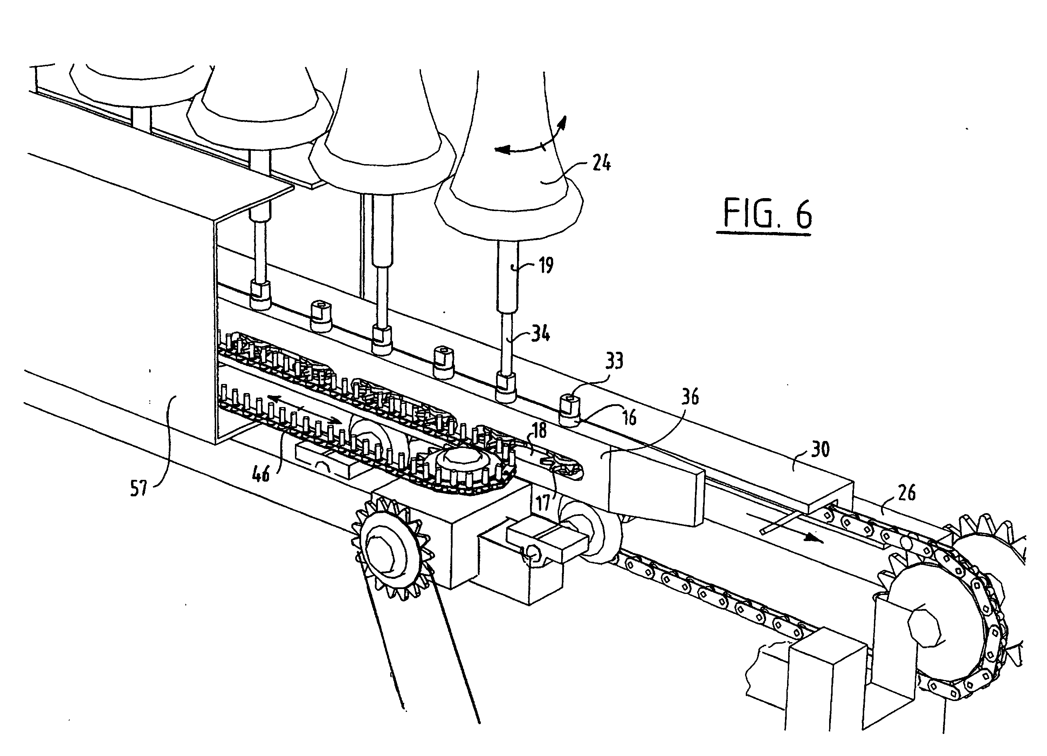

Various aspects are shown in more detail in figure 6.

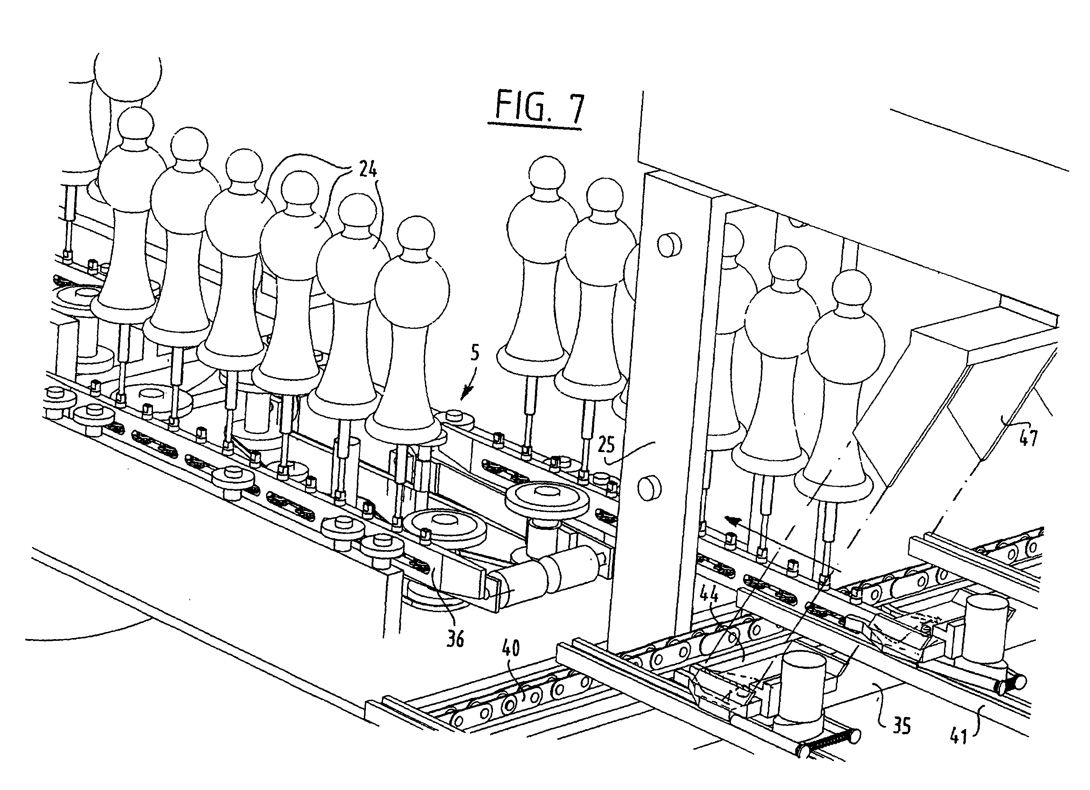

Figure 7 shows in more detail the mechanism with which the movements of supports 41 to the transport device 5 within the vacuum metallization device are executed, and vice versa.

This shows the construction of the linear drive device 43 which is connected by means of a frame 47 to a pushing device 44.

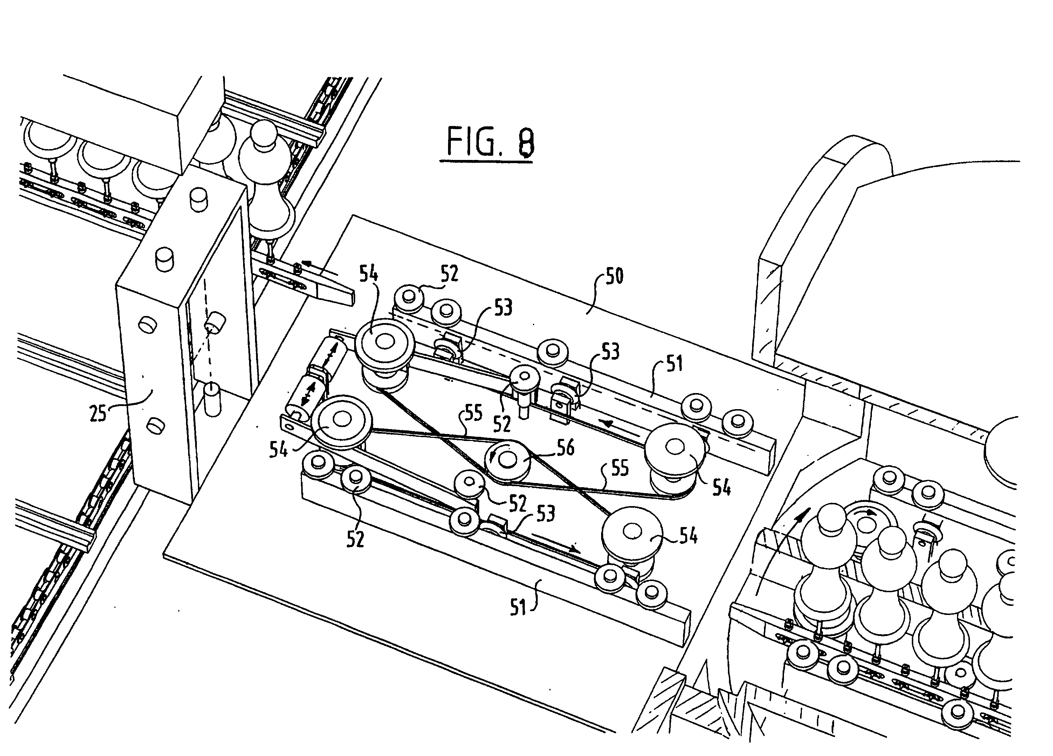

Figure 8 shows in more detail a part of the drive device for transport of carriers 15 inside the vacuum metallization device. The relevant elements are herein mounted on a plate 50, on which are arranged two beams 51 on which guide wheels with guide shafts 52 are mounted. In the middle of each of these beams 51 a guide wheel 52 is further arranged on the other side of the path of the carrier. Finally, support wheels 53 are arranged.

Drive wheels 55 are also arranged for driving the carrier 15. Drive wheels 54 are herein driven by means of belts 55. Both belts 55 are trained round a wheel 56 which is driven by a motor mounted beneath the plate. This drawing also shows that a check gate device is again placed in order to determine whether all objects are present on the carrier.

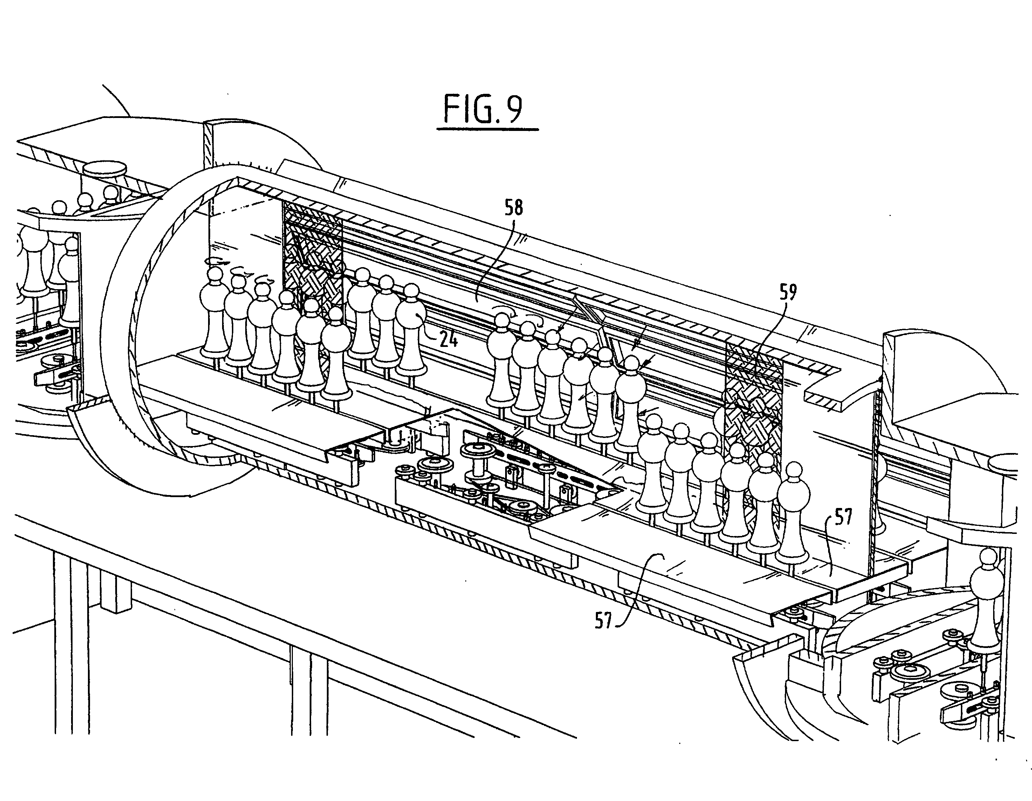

Figure 9 shows the construction of the vacuum metallization chamber 4, which otherwise forms the subject-matter of the European patent application 98.203444.9. Here also the same drive device is used. This is further of importance in that plates 57 are arranged to protect the transport device against precipitation of metal. Such plates are otherwise also arranged in the paint spraying devices.

This figure further shows how the actual targets 58 of the magnetron sputtering device are arranged at two different levels. In combination with the different heights of the extension shafts it is thus possible to determine the height and direction of the metallization process.

In the present construction the objects for processing pass twice through the magnetron sputtering device, wherein only one of the two passages is effective. The active half of the device is separated from the non-active half of the device by a partition wall 59 of a material on which the sputtered vapour will deposit but which can be removed easily.

Finally, figure 10 shows the construction of product carriers 15. The product carriers are placed on top of the extension shafts to carry the products for processing. In the present case the product carriers are formed by a piece of threaded end which can be placed on the extension shaft, wherein discs provided with internal thread can be placed on the threaded ends, the form and position of which discs can be adapted to the relevant products.

## Claims

1. Apparatus for applying at least one coating to objects by means of vapour deposition (PVD) under vacuum, comprising:
- a PVD device for coating the object under a vacuum;
- at least one lock separating the PVD-device from the ambient;
- a transport device which extends though the PVD-device and into the lock;
- wherein the transport device is adapted to transport objects arranged on carriers;
- the PVD device is adapted for semi-continuous treatment of objects arranged on the carriers;
- a preprocessing device for performing a preprocessing on the object;
- a postprocessing device for postprocessing the objects; and
- wherein the transport device extends though said at least one lock, the preprocessing device and the postprocessing device,
**characterized in that** the preprocessing device comprises an application device for applying onto the objects for treating a lacquer which cures with radiation, for instance UV or IR radiation, and a device for irradiating the lacquered objects with the relevant radiation.

2. Apparatus as claimed in claim 1, **characterized in that** the preprocessing device comprises a blower device for blowing dust from the objects for treating.

3. Apparatus as claimed in claim 1 or 2, **characterized in that** the preprocessing device comprises a surface processing device connected prior to the application device for processing the surface of the objects for treating.

4. Apparatus as claimed in any of the foregoing claims, **characterized in that** the postprocessing device comprises an application device for applying onto the objects for treating a lacquer which cures with radiation, for instance UV radiation, and a device for irradiating the lacquered objects with the relevant radiation.

5. Apparatus as claimed in any of the foregoing claims, **characterized in that** a loading/unloading station is placed between the postprocessing device and the preprocessing device for unloading processed objects and loading objects for processing.

6. Apparatus as claimed in one of the preceding claims, **characterized in that** the carriers are elongate, that object holders are present on the carriers, the object holders are rotatable and the transport device is adapted to move the carriers substantially in the longitudinal direction and to rotate the object holders in the PVD-device.

7. Apparatus as claimed in claim 6, **characterized in that** the PVD device is connected to the ambient by means of a single lock, the transport device extends through the lock and the lock is adapted to feed a carrier simultaneously into and out of the PVD device.

8. Apparatus as claimed in claim 7, **characterized in that** the transport device has a closed configuration and extends in two directions through the PVD device.

9. Apparatus as claimed in claim 8, **characterized in that** a buffer for the carriers is arranged between the preprocessing device and the PVD device.

10. Apparatus as claimed in claim 9, **characterized in that** a buffer for the carriers is arranged between the PVD device and the postprocessing device.

11. Apparatus as claimed in claim 9 or 10, **characterized in that** the buffers are adapted to move the carriers in transverse direction.

12. Apparatus as claimed in one the claims 6-11, **characterized in that** the object holders are interchangeable object holders.

13. Apparatus as claimed in claim 12, **characterized in that** the object holders are placed on vertically extending shafts mounted rotatably in the carriers.

14. Apparatus as claimed in claim 13, **characterized in that** toothed wheels are arranged on the shafts for driving the shafts in rotation.

15. Apparatus as claimed in claim 14, **characterized in that** the toothed wheels are arranged under the top side of the carrier.

16. Apparatus as claimed in claim 15, **characterized in that** the toothed wheels are let into openings arranged in the carrier and the toothed wheels protrude outside the side walls of the carrier.

17. Apparatus as claimed in any of the claims 6-16, **characterized in that** the apparatus is provided with cams for engaging in and rotating the toothed wheels during passage of the carriers.

18. Apparatus as claimed in claim 17, **characterized in that** the cams form part of a drivable chain for causing the shafts to rotate independently of the linear movement of the carrier.

## Patentansprüche

1. Vorrichtung zur Aufbringung wenigstens eines Überzuges auf Gegenstände mittels einer Dampfablagerung (PVD) unter Unterdruck, aufweisend:
- eine PVD-Vorrichtung zum Überziehen des Gegenstandes unter Unterdruck;
- wenigstens eine Schleuse, die die PVD-Vorrichtung von der Umgebung trennt;
- eine Transportvorrichtung, die sich durch die PVD-Vorrichtung und in die Schleuse hinein erstreckt;
- wobei die Transportvorrichtung dazu angepasst ist, Gegenstände, die auf Trägern angeordnet sind, zu transportieren,
- die PVD-Richtung für eine halbkontinuierliche Behandlung der Gegenstände, die auf den Trägern angeordnet sind, angepasst ist,
- eine Vorverarbeitungsvorrichtung zur Durchführung einer Vorverarbeitung an dem Gegenstand;
- eine Nachverarbeitungsvorrichtung zum Nachverarbeiten der Gegenstände, und
- wobei sich die Transportvorrichtung durch die wenigstens eine Schleuse, die Vorverarbeitungsvorrichtung und die Nachverarbeitungsvorrichtung erstreckt,
**dadurch gekennzeichnet, dass** die Vorverarbeitungsvorrichtung eine Anwendungsvorrichtung zum Aufbringen eines Lackes auf die zu behandelnden Gegenstände aufweist, der mittels Strahlung, beispielsweise UV- oder IR-Strahlung, aushärtet, und eine Vorrichtung zum Bestrahlen der lackierten Gegenstände mit der relevanten Strahlung.

2. Vorrichtung gemäß Anspruch 1, **dadurch gekennzeichnet, dass** die Nachverarbeitungsvorrichtung eine Gebläsevorrichtung zum Ausblasen von Staub von den zu behandelnden Gegenständen aufweist.

3. Vorrichtung gemäß Anspruch 1 oder 2, **dadurch gekennzeichnet, dass** die Vorverarbeitungsvorrichtung eine Oberflächenverarbeitungsvorrichtung aufweist, die vor der Anwendungsvorrichtung zur Bearbeitung der Oberfläche der zu behandelnden Gegenstände verbunden ist.

4. Vorrichtung gemäß einem der vorhergehenden Ansprüche, **dadurch gekennzeichnet, dass** die Nachverarbeitungsvorrichtung eine Anwendungsvorrichtung zum Aufbringen eines Lackes,auf die zu behandelnden Gegenstände aufweist, der mit Strahlung, beispielsweise W-Strahlung aushärtet, und eine Vorrichtung zur Bestrahlung der lackierten Gegenstände mit der relevanten Bestrahlung.

5. Vorrichtung gemäß einem der vorhergehenden Ansprüche, **dadurch gekennzeichnet, dass** eine Beladungs-/Entladungs-Station zwischen der Nachverarbeitungsvorrichtung und der vorverarbeitungsvorrichtung zum Entladen der bearbeiteten Gegenstände und zum Beladen von zu bearbeitenden Gegenständen angeordnet ist.

6. Vorrichtung gemäß einem der vorhergehenden Ansprüche, **dadurch gekennzeichnet, dass** die Träger länglich sind, dass sich Gegenstandshalter auf den Trägern befinden, dass die Gegenstandshalter drehbar sind und die Transportvorrichtung dazu angepasst ist, die Träger im wesentlichen in der Längsrichtung zu bewegen und die Gegenstandshalter in der PVD-Vorrichtung zu drehen.

7. Vorrichtung gemäß Anspruch 6, **dadurch gekennzeichnet, dass** die PVD-Vorrichtung mittels einer einzigen Schleuse mit der Umgebung verbunden ist, sich die Transportvorrichtung durch die Schleuse erstreckt und die Schleuse dazu angepasst ist, einen Träger gleichzeitig in und aus der PVD-Vorrichtung zu transportieren.

8. Vorrichtung gemäß Anspruch 7, **dadurch gekennzeichnet, dass** die Transportvorrichtung eine geschlossene Konfiguration besitzt und sich in zwei Richtungen durch die PVD-Vorrichtung erstreckt.

9. Vorrichtung gemäß Anspruch 8, **dadurch gekennzeichnet, dass** ein Puffer für die Träger zwischen der Vorverarbeitungsvorrichtung und der PVD-Vorrichtung angeordnet ist.

10. Vorrichtung gemäß Anspruch 9, **dadurch gekennzeichnet, dass** ein Puffer für die Träger zwischen der PVD-Vorrichtung und der Nachverarbeitüngsvorrichtung angeordnet ist.

11. Vorrichtung gemäß Anspruch 9 oder 10, **dadurch gekennzeichnet, dass** die Puffer dazu angepasst sind, die Träger in einer transversalen Richtung zu bewegen.

12. Vorrichtung gemäß einem der Ansprüche 6 bis 11, **dadurch gekennzeichnet, dass** die Gegenstandshalter austauschbare Gegenstandshalter sind.

13. Vorrichtung gemäß Anspruch 12, **dadurch gekennzeichnet, dass** die Gegenstandshalter auf sich vertikal erstreckenden Wellen angeordnet sind, die drehbar in den Trägern montiert sind.

14. Vorrichtung gemäß Anspruch 13, **dadurch gekennzeichnet, dass** gezahnte Räder auf den Wellen zum drehenden Antreiben der Wellen angeordnet sind.

15. Vorrichtung gemäß Anspruch 14, **dadurch gekennzeichnet, dass** gezahnte Räder unter der Oberseite des Trägers angeordnet sind.

16. Vorrichtung gemäß Anspruch 15, **dadurch gekennzeichnet, dass** die gezahnten Räder in Öffnungen eingelassen werden, die in dem Träger angeordnet sind, und dass die gezahnten Räder aus den Seitenwänden des Trägers hervorstehen.

17. Vorrichtung gemäß einem der Ansprüche 6 bis 16, **dadurch gekennzeichnet, dass** die Vorrichtung mit Nocken versehen ist, um mit den gezahnten Rädern während des Durchlaufs der Träger in Eingriff zu gelangen und die gezahnten Räder zu drehen.

18. Vorrichtung gemäß Anspruch 17, **dadurch gekennzeichnet, dass** die Nocken einen Teil einer antreibbaren Kette bilden, um die Wellen dazu zu bringen, unabhängig von der linearen Bewegung des Trägers zu rotieren.

## Revendications

1. Appareil pour l'application d'au moins un revêtement sur des objets au moyen d'une déposition en phase vapeur (PVD) sous vide, comprenant :
- un dispositif de PVD pour le revêtement sous vide de l'objet ;
- au moins un sas séparant le dispositif de PVD du milieu ambiant ;
- un dispositif de transport qui traverse le dispositif de PVD et pénètre dans le sas;
- dans lequel le dispositif de transport est adapté pour transporter les objets disposés sur des convoyeurs ;
- le dispositif de PVD est adapté pour assurer le traitement en semi-continu d'objets disposés sur les convoyeurs ;
- un dispositif de pré-traitement pour réaliser un pré-traitement des objets ;
- un dispositif de post-traitement pour réaliser un post-traitement des objets ; et
- dans lequel le dispositif de transport traverse ledit sas au nombre d'un au moins, le dispositif de pré-traitement et le dispositif de post-traitement,
**caractérisé en ce que** le dispositif de pré-traitement comprend un dispositif d'application pour appliquer sur les objets à traiter une laque qui durcit sous l'action d'un rayonnement, par exemple d'un rayonnement UV ou IR, et un dispositif pour exposer au rayonnement correspondant les objets laqués.

2. Appareil selon la revendication 1, **caractérisé en ce que** le dispositif de pré-traitement comprend une soufflante destinée à dépoussiérer les objets à traiter.

3. Appareil selon la revendication 1 ou 2, **caractérisé en ce que** le dispositif de pré-traitement comprend un dispositif de traitement de la surface monté en amont du dispositif d'application pour le traitement de la surface des objets à traiter.

4. Appareil selon l'une ou l'ensemble des revendications précédentes, **caractérisé en ce que** le dispositif de post-traitement comprend un dispositif d'application destiné à appliquer sur les objets à traiter une laque qui durcit sous l'action d'un rayonnement, par exemple d'un rayonnement UV, et un dispositif pour exposer au rayonnement correspondant les objets laqués.

5. Appareil selon l'une ou l'ensemble des revendications précédentes, **caractérisé en ce qu'**un poste de chargement et déchargement est prévu entre le dispositif de post-traitement et le dispositif de pré-traitement pour décharger les objets traités et charger les objets à traiter.

6. Appareil selon l'une ou l'ensemble des revendications précédentes, **caractérisé en ce que** les convoyeurs sont allongés, **en ce que** des porte-objets sont prévus sur les convoyeurs, les porte-objets sont rotatifs et le dispositif de transport est adapté pour déplacer les convoyeurs sensiblement dans le sens longitudinal et à faire tourner les porte-objets dans le dispositif de PVD.

7. Appareil selon la revendication 6, **caractérisé en ce que** le dispositif de PVD communique avec le milieu ambiant au moyen d'un seul sas, le dispositif de transport traverse le sas et le sas est adapté pour faire entrer et sortir simultanément un convoyeur du dispositif de PVD.

8. Appareil selon la revendication 7, **caractérisé en ce que** le dispositif de transport a une configuration fermée et traverse le dispositif de PVD dans deux directions.

9. Appareil selon la revendication 8, **caractérisé en ce qu'**un tampon de convoyeurs est prévu entre le dispositif de pré-traitement et le dispositif de PVD.

10. Appareil selon la revendication 9, **caractérisé en ce qu'**un tampon de convoyeurs est disposé entre le dispositif de PVD et le dispositif de post-traitement.

11. Appareil selon la revendication 9 ou 10, **caractérisé en ce que** les tampons sont adaptés pour déplacer les convoyeurs dans le sens transversal.

12. Appareil selon l'une ou l'ensemble des revendications 6 à 11, **caractérisé en ce que** les porte-objets sont des porte-objets interchangeables.

13. Appareil selon la revendication 12, **caractérisé en ce que** les porte-objets sont disposés sur des tiges s'étendant verticalement et montées avec possibilité de rotation dans les convoyeurs.

14. Appareil selon la revendication 13, **caractérisé en ce que** des roues dentées sont disposées sur les tiges pour entraîner les tiges en rotation.

15. Appareil selon la revendication 14, **caractérisé en ce que** des roues dentées sont disposées sur la face supérieure du convoyeur.

16. Appareil selon la revendication 15, **caractérisé en ce que** les roues dentées sont introduites dans des ouvertures ménagées dans le convoyeur et font saillie à l'extérieur de parois latérales du convoyeur.

17. Appareil selon l'une ou l'ensemble des revendications 6 à 16, **caractérisé en ce que** l'appareil est pourvu de cames destinées à se mettre en prise avec les roues dentées et à faire tourner celles-ci pendant le passage des convoyeurs.

18. Appareil selon la revendication 17, **caractérisé en ce que** les cames font partie d'une chaîne pouvant être entraînée et destinée à faire tourner les tiges indépendamment du mouvement linéaire du convoyeur.
